# EUROPEAN PATENT APPLICATION

(11) **EP 1 577 939 A2**
(43) Date of publication of application: **21.09.2005**
(21) Application number: 05003843.9
(22) Date of filing: 23.02.2005
(51) Int. Cl.: H01L 21/768

(54) **Method of manufacturing a semiconductor device having damascene structures with air gaps**

(30) Priority: 18.03.2004 EP 04101107
(71) Applicant: Interuniversitair Microelektronica Centrum, 3001 Leuven (BE); Koninklijke Philips Electronics N.V., 5621 BA Eindhoven (NL)
(72) Inventor: Daamen, Roel, 6061 NE Posterholt (NL); Verheijden, Greja Johanna Adriana Maria, 5551 AT Valkenswaard (NL)
(74) Representative: Bird, Ariane

(57) **Abstract**

A method for manufacturing a semiconductor device having damascene structures with air gaps is provided. The method comprises the steps of providing a substantially planar layer having a first metal layer (M1), depositing a via level dielectric layer (VL), patterning the via level dielectric layer (VL), at least partly etching the via level dielectric layer (VL), depositing a disposable layer (PR) on said at least partly etched via level dielectric layer (VL), patterning said disposable layer (PR), depositing a second metal layer (M2), planarizing second metal layer (M2), depositing permeable dielectric layer (PDL) after planarizing said second metal layer (M2), and removing said disposable layer (PR) through said permeable dielectric layer (PDL) to form air gaps (AG).

## Description

The invention relates to a method for manufacturing a semiconductor device having damascene structures with air gaps as well as an accordingly manufactured semiconductor device.

The trend towards integrated circuits with deep submicron technology (i.e., involving feature sizes less than 0.35 microns) has increased the need for multi-layer interconnects. The performance of integrated circuits in the deep submicron regime is increasingly dependent on the communication delay, i.e. the delay time of electronic signals traveling between the millions of gates and transistors present on the typical integrated circuits. As a result, capacitance and resistance effects resulting from the passive interconnect structures are increasingly becoming important and do have to be well-controlled.

One way to solve the above problems is to use low resistance metals (e.g., copper) in conjunction with insulating materials with low dielectric constants ("low-k dielectrics") between metal lines. A low-k dielectric is a dielectric material, which exhibits a dielectric constant substantially less than conventional dielectric materials such as silicon dioxide.

Based on considerable efforts optical lithography techniques have been able to keep up with deep submicron requirements using techniques such as off-axis illumination, phase shifting masks, and other methods known in the art. However, the achieved increase in resolution is paid by a decrease in the depth of focus. Therefore, highly planar surfaces are required during intermediary process steps. To achieve highly planar surfaces, traditional metal deposition and photolithographic techniques become progressively more ineffective as line widths are scaled down and multiple layers of metal are used.

Chemical-Mechanical Polishing (CMP) is increasingly being used in the fabrication of interconnect layers for modem integrated circuits especially with more than three layers. The metal lines thereof usually comprise a high aspect ratio (e.g., lines in the order of 0.25 µm in width and in the order of 1.0 µm in height). For more detail on the CMP please refer to the introductory part of US 6,071,809.

A typically semiconductor manufacturing technique based on the CMP techniques is the so-called damascene process. A damascene process comprises the steps of forming patterns in a dielectric layer, filling these patterns with an interconnect metal, removing the excess metal on the wafer surface by polishing and leaving inlaid interconnect metal features.

Basically two damascene processes exist, namely the single-damascene and the dual-damascene process. In a single damascene process, a lower conductor is formed on a substrate and is coated with a first dielectric layer. The lower conductor is contacted by patterning the first dielectric layer and forming a conductive plug in the first dielectric layer. Thereafter, a second dielectric layer deposited on the first dielectric layer is patterned and an interconnect wiring metallization is formed in the patterned second dielectric layer. In addition a dielectric is deposited, the structures are etched and the metal is filled and planarized resulting in in-laid metal structures. During the fabrication and the interconnecting using single damascene processing, every layer is done separately, i.e. a single damascene trench level followed by single damascene via level. However, in a dual-damascene process, the interconnect metal wiring and the conductive plug are formed by patterning both the via and the trench patterns into the first dielectric layer. Thereafter, the via and the trench are filled simultaneously with metal. The dual damascene process provides a simple and low cost manufacturing technique.

Copper is preferred over aluminum for interconnect metallization as its conductivity is relatively high, i.e. low resistance, and it is less susceptible to electromigration failure than many other metals. On the other hand, the use of Cu as interconnect metal introduces new problems, since bringing copper in contact with silicon or silicon dioxide may lead to devastating results. This is because copper migrates or diffuses into the silicon dioxide increasing leakage currents or actually shorting-out adjacent conductors. Accordingly, some kind of Cu diffusion barriers around copper conductors must be introduced. In the above damascene structures, the inner surfaces (i.e., the bottom and sides of the via and trench) are typically coated with a thin layer of Ti, TiN, Ta, TaN, WN or another adequate barrier metal. The top surface of a Cu conductor is then typically capped with a layer of silicon nitride or another barrier material after the inlaid Cu conductors are formed by CMP. Silicon nitride, silicon carbide or silicon carbo nitride is typically used as it is an effective diffusion barrier for copper.

In US 6,071,809 a typical prior art low-k dual-damascene structure is shown, which includes copper conductors formed on a substrate with a dielectric (e.g., silicon dioxide or a low-k dielectric). A nitride cap layer is formed on copper conductors, which is followed by a low-k dielectric layer, an etch stop silicon dioxide layer, a second low-k dielectric layer, and a hard mask silicon dioxide layer. Using standard etching techniques, vias and trenches are patterned in the low-k dielectrics, and the copper interconnect metal and any seed and barrier layers are deposited to form the connection to conductor. The cap layer typically consists of silicon nitride and hard mask layer typically consists of silicon dioxide.

Usually, advanced low-k materials have a bulk k-value of approximately 2, while air has a k-value of 1. Therefore, the use of air gaps instead of low-k materials would lead to a significant reduction of parasitic capacitance. One example of a damascene structure with air gaps is shown in WO 02/19416. A standard dual damascene structure is be manufactured as described in US 6,071,809. Accordingly, the dual damascene structure comprises a metal layer, a first dielectric layer as via dielectric (low-k dielectrics such as siloxane or a polyarylene ether), a second dielectric layer (such as SOG, NanoglassTM or a polymer like SiLK) disposed on said first dielectric layer as trench level dielectric with an interconnect groove. In addition, an etch stopper layer (such as SiN) is present between the first dielectric layer and the second dielectric layer. Metal, preferably copper Cu, fills the via and the interconnect groove forming a metal line having an upper side. A barrier and the Cu seed layer is provided on the walls of the via and the interconnect groove before depositing the Cu. The second dielectric layer is removed so that the metal which has filled the interconnect grove at trench level is laid open, i.e. the second dielectric layer is used as a sacrificial layer for defining the metal lines. A non-conductive barrier layer (like silicon nitride or silicon carbide) is provided over the laid open metal line and the laid open etch stop layer. A disposable layer is deposited on the etch stop layer and the metal line. Thereafter, the disposable layer is planarized down to the upper side of the metal line. A porous dielectric layer is spun on the disposable layer, and the disposable layer is removed or decomposed through the porous dielectric layer in order to form air gaps. The air gaps are obtained through a curing and baking step possibly assisted with UV treatment.

The spin-on material of the porous dielectric layer comprises a polymer which can be volatilized or degraded to smaller molecules, like PMMA (polymethyl methacrylate), polystyrene, and polyvinyl alcohol. Alternatively, a UV photo resist may also be used as the basic material for the manufacture of air gaps, and a plasma CVD layer or a spin-on dielectric layer is used for the porous dielectric layer. The porous dielectric layer preferably comprises a low-k dielectric such as SiLK, provided in a spin coating process. A plasma CVD layer may also be used as the porous dielectric layer.

It is an object of the invention to provide a cheaper manufacturing of a semiconductor device with damascene structures and air gaps.

This object is solved by a method for manufacturing a semiconductor device having damascene structures with air gaps according to claim 1 as well as a semiconductor device according to claim 8.

Therefore, a method for manufacturing a semiconductor device having damascene structures with air gaps is provided. The method comprises the steps of: providing a substantially planar layer having a first metal layer, depositing a via level dielectric layer, patterning the via level dielectric layer, at least partly etching the via level dielectric layer , depositing disposable layer on said at least partly etched via level dielectric layer, patterning said disposable layer, depositing a second metal layer, planarizing second metal layer, depositing permeable dielectric layer after planarizing second metal layer, and removing said disposable layer through said permeable layer to form air gaps.

Accordingly, the above manufacturing method needs less processing steps to manufacture a semiconductor device with air gaps at trench level as compared to the method disclosed in US 6,071,809 and WO 02/19416. Thus a cheaper manufacturing process is achieved.

According to an aspect of the invention said disposable layer is a photo resist layer or an organic polymer layer with a low mass. Hence, the disposable layer can be easily decomposed.

According to a further aspect of the invention said photo resist layer is spun on said at least partly etched via level dielectric layer forming an easy and well known deposition step.

According to still a further aspect of the invention a further barrier layer is deposited after the planarizing of said second metal layer, whereby the first metal layer is fully encapsulated by a diffusion barrier layer preventing a migration of Cu atoms.

According to a further aspect of the invention said patterning and etching of said via level dielectric layer is adapted to provide additional via holes in said via level dielectric layer to provide metal dummy structures in the via level dielectric layer after said removing step. These metal dummy structures improve the mechanical stability of the air gaps.

According to a further aspect of the invention, a single CVD reactor is used for performing the heating step to decompose the disposable layer and for depositing a trench dielectric layer a subsequent step. Thus the usage of a stand-alone oven for the decomposing of the disposable layer can be omitted decreasing the required amount of apparatus and increasing the throughput.

The invention also relates to a semiconductor device having damascene structures with air gaps comprising a substantially planar layer with a first metal layer, a patterned and at least partly etched via level dielectric layer on said first metal layer, a patterned disposable layer deposited on said at least partly etched via level dielectric layer, a planarized second metal layer, a permeable dielectric layer deposited on said planarized second metal layer, and at least one air gap formed by removing said disposable layer through said permeable dielectric layer.

Other aspects of the invention are defined in the dependent claims.

These and other aspects of the invention are apparent from and will be elucidated with reference to the embodiment(s) described hereinafter.

Figs. 1 to 12 show a number of processing steps according to a method for manufacturing a semiconductor device:
Fig. 1 shows a cross section of a semiconductor device according to the invention as starting point,
Fig. 2 shows a cross section of the device of Fig. 1 after a deposition of a via level dielectric,
Fig. 3 shows a cross section of the device of Fig. 2 after patterning a deposited imaging layer/resist,
Fig. 4a shows a cross section of the device of Fig. 3 after etching the via in the dielectric layer and removing the imaging layer/resist,
Fig. 4b shows a cross section of the device of Fig. 3 after partially etching the via in the dielectric layer and removing the imaging layer/resist,
Fig. 5a shows a cross section of the device of Fig. 4a after spinning photo resist on the etched layers,
Fig. 5b shows a cross section of the device of Fig. 4b after spinning photo resist on the partly etched layers,
Fig. 6a shows a cross section of the device of Fig. 5a after patterning the photo resist,
Fig. 6b shows a cross section of the device of Fig. 5b after patterning the photo resist,
Fig. 7a shows a cross section of the device of Fig. 5a after patterning the photo resist which is ready for further processings,
Fig. 7b shows a cross section of the device of Fig. 5b after a continued etching of the vias,
Fig. 8 shows a cross section of the device of Figs. 7a or 7b after etching through a diffusion barrier layer on top of a first metal layer,
Fig. 9 shows a cross section of the device of Fig. 8 after a barrier layer deposition and a seed layer deposition,
Fig. 10 shows a cross section of the device of Fig. 9 after a metal plating step,
Fig. 11 shows a cross section of the device of Fig. 10 after a planarization step and a spinning on of a permeable dielectric layer, and
Fig. 12 shows a cross section of the device after decomposing the trench level photo resist.

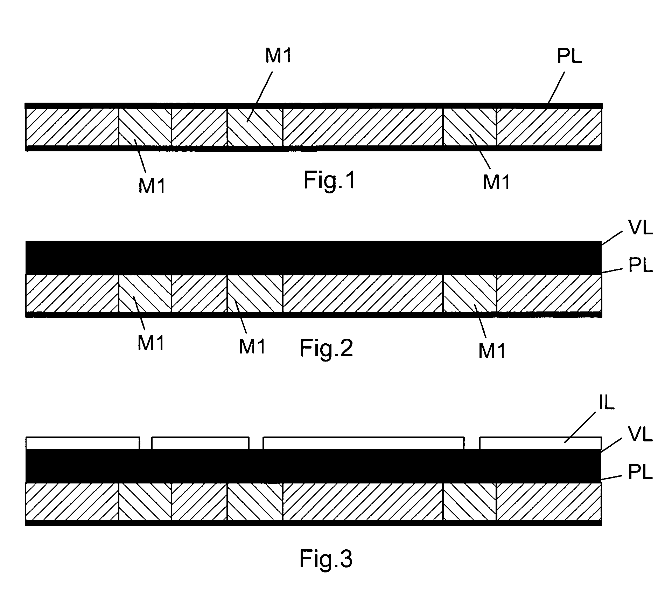

Figure 1 shows a cross section of a semiconductor device as starting point for the manufacturing process of a semiconductor device according to a first preferred embodiment of the invention. An alternative starting point may also be a single damascene metal 1 structure with air gaps. In particular, a first level metal interconnect layer M1 is shown with dielectric material in between and a passivation layer PL on top of the metal interconnect layer and the dielectric layer. The passivation layer PL is also used as diffusion barrier layer, i.e. as bottom hard mask and may be SiC, SiCN, Si3N4, a self-aligned electroless deposited barrier such as CoWP or CoWB.

Figure 2 shows a cross section of the device of figure 1 after a deposition of a via level dielectric material VL. The via level dielectric material is deposited on the diffusion barrier layer PL either by spin coating the material or by chemical vapor deposition CVD. The via level dielectric material VL is preferably an oxide based material.

Figure 3 shows a cross section of the device of figure 2 after patterning a deposited imaging layer/resist IL. An imaging layer/resist IL is deposited, preferably by spinning, on the via level dielectric VL and a lithography is performed to pattern the via level dielectric VL.

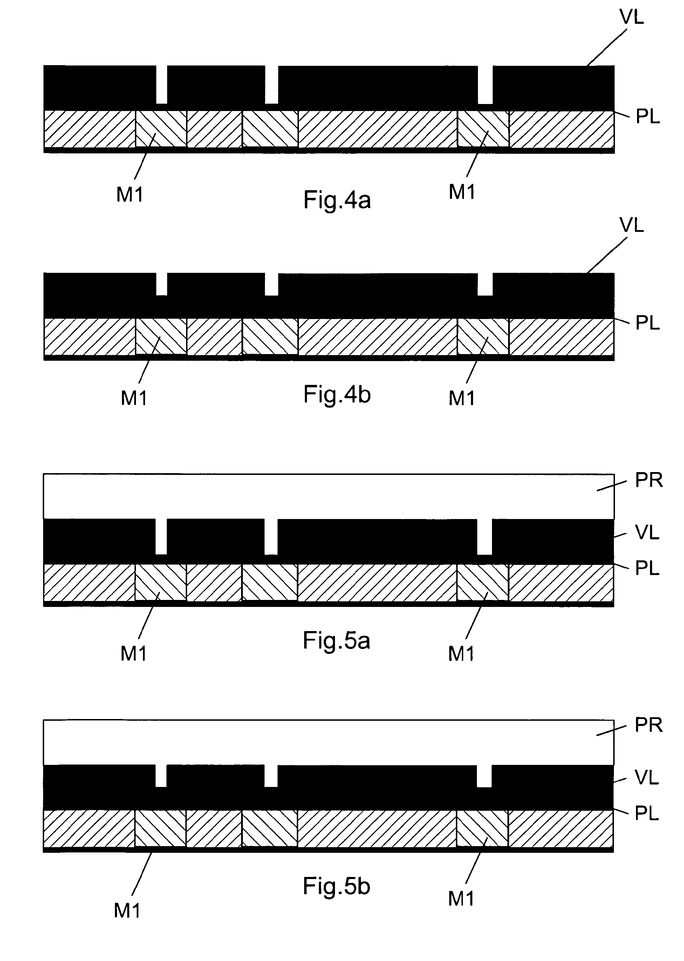

Figure 4a shows a cross section of the device of figure 3 after etching the imaging layer and the via level dielectric layer. Here, the via in the dielectric layer is etched down to the barrier layer PL at those areas which were not covered by the patterned imaging layer/resist IL. Accordingly, the respective vias are provided. This etching step can be performed by dry etching.

Figure 4b shows a cross section of the device after etching the imaging layer and partly etching the via level dielectric layer VL. Here, the imaging layer IL is completely removed and additionally the via level dielectric is only partly removed at those areas which were not covered by the patterned imaging layer IL. Accordingly, the respective vias are only partially etched and further processing will be required. This removing step can be performed by dry etching.

Figure 5a and figure 5b show a cross section of the device after spinning photo resist PR on the etched layers of figure 4a and figure 4b, respectively. A standard resist PR is deposited onto the device of figure 4a or figure 4b. This may be done by spinning the resist onto the wafer filling the etched via holes. The photo resist layer constitutes the trench level dielectric material. Alternatively, the spin-on layer may also be an organic polymer with a low mass (i.e. a low amu), that decomposes at temperatures between 300°C and 500°C, preferably between 350°C and 450°C.

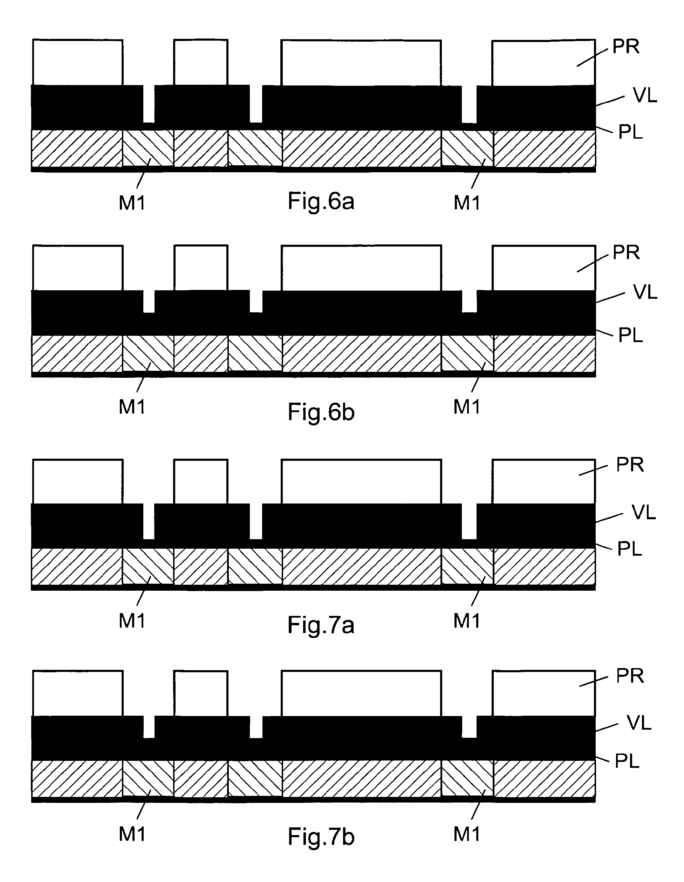

Figure 6a and figure 6b show a cross section of the device after patterning the photo resist of figure 5a and figure 5b, respectively. Here, the lithography for the trench level is performed on the via level dielectric VL which is covered with the resist.

Figure 7a shows a cross section of the device after patterning the photo resist of figure 5a which is ready for further processing. The via holes are etched down to the diffusion barrier layer.

In figure 7b a cross section of the device of figure 5b after a continued etching of the vias is shown. After a further etching step, the via holes are fully etched down to the diffusion barrier layer as well. This etch step is performed by a selective etching leaving the resist unaffected, e.g. a standard oxygen etch may be used for organic exposed resist.

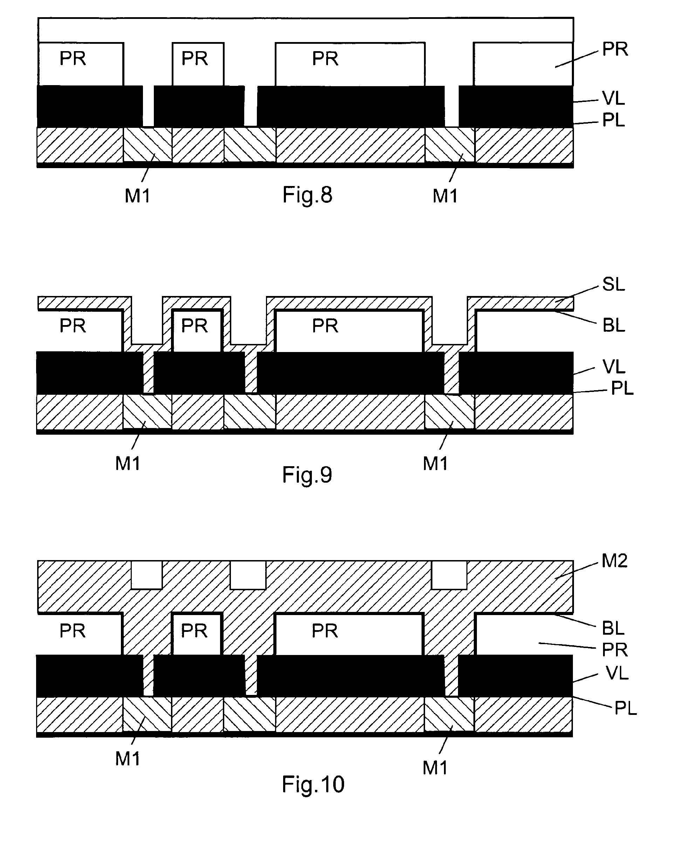

Figure 8 shows a cross section of the device of figures 7a or 7b after etching through a diffusion layer on top of a first metal layer. Here, a dry etch not attacking the resist is used, i.e. the bottom mask is opened without etching the resist on top of the via level dielectrics VL.

Figure 9 shows a cross section of the device of figure 8 after a barrier layer deposition and a seed layer deposition. The diffusion barrier layer BL deposition and the Cu seed deposition are performed by physical vapor deposition PVD or a CVD technique. The barrier layer BL may comprise Ta, TaN, Ti, TiN, WCN, or combinations thereof or any other suitable metallic diffusion barrier layer.

Figure 10 shows a cross section of the device of figure 9 after a copper plating step.

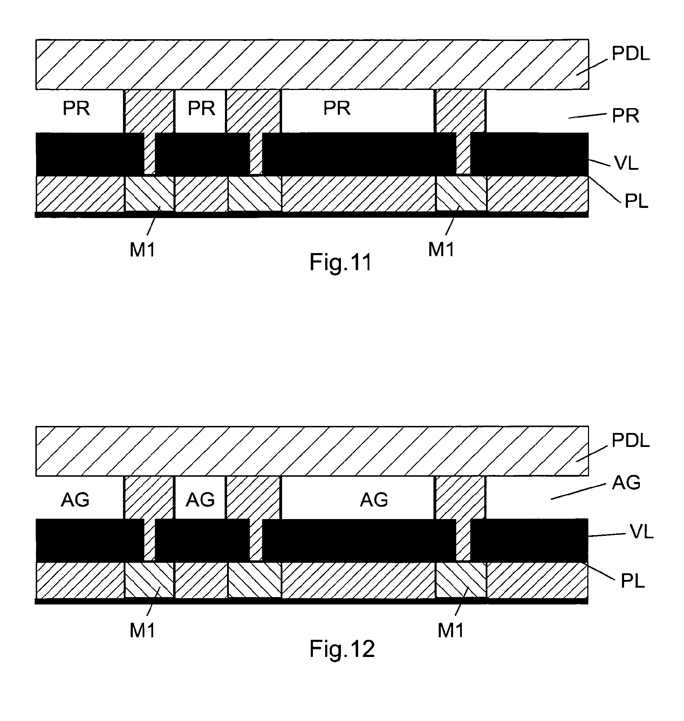

Figure 11 shows a cross section of the device of figure 10 after a planarization step and a spinning on of a permeable dielectric layer. The planarization of the copper is performed by Chemical-Mechanical Polishing CMP. Thereafter, a permeable dielectric material having a low-k value is spun onto the CMP treated surface.

Figure 12 shows a cross section of the device after decomposing the trench level photo resist. The trench level resist which is used as sacrificial material is decomposed by heating the wafer. The trench level material decomposes and diffuses through the permeable dielectric material PDL. Finally, the required air gaps AG are present in the volume previously occupied by the decomposed material PR.

The above mentioned semiconductor manufacturing process may be used in all CMOS, RFCMOS and BiCMOS processes.

Summarizing, the manufacturing process according the preferred embodiment is different from the technique used in WO 02/19416, where first a standard Dual Damascene structure is obtained and then the dielectric is removed, a diffusion barrier is deposited, resist is deposited, the resist is planarized, a porous dielectric is deposited and then the sacrificial material is decompose. Furthermore, the proposed technique is cheaper as multiple processing steps can be left out.

A semiconductor device manufactured as described above will be different from prior art semiconductor devices as an oxide(like) material will be present at the via-level with the air gaps at trench level. A following via-level on top of this structure is made out of a porous material. This already shows what technique has been used. Also here, due to the use of the sacrificial material there might be some very small amount of carbon-like material inside the air cavity, more precise at the Tantalum interface protecting the copper. And last but not least, due to the technique that is used, especially the "via not fully etched until the bottom" one will see very smooth and rounded vias.

According to a second embodiment which is based on the first embodiment two further process steps are introduced after performing the CMP on the copper layer. In particular, a second barrier layer deposition is performed on the planarized copper layer M2 and the planarized photo resist layer PR. The deposited second barrier layer on top of the resist is removed using CMP leaving the second barrier layer on top of the copper layer substantially intact. The advantage of these further process step are that the copper metal lines and layers are completely encapsulated by a diffusion barrier layer preventing a migration of Cu atoms.

In other words a capping of the copper layer is performed before the depositing the permeable via-layer. However, also other capping methods may be implemented, like self-aligned electroless deposited barrier such as CoWP or CoWB and even a SiC/Si3N4 etc deposition followed by a lithography step and an etch step removing a liner from the top of the spacing, but leaving it on the copper thus capping/passivating this layer.

According to a third embodiment which may be based on the first or second embodiment metal dummies are introduced into the air gaps to increase the mechanical stability thereof. This may be achieved by adapting the lithography step as depicted in figure 6a and 6b such that additional gaps are introduced into the resist layer. These additional gaps should be formed on top of the photo resist in between the trenches. Thereafter, the diffusion barrier layer deposition, the seed layer deposition and the subsequent processing steps as described according to the first or second embodiment are preformed. Since the additional gaps in the photo resist are arranged at positions in between the trenches and are filled with copper, the copper in the additional gaps is not interconnected with other metal lines and thus merely serves for increasing the stability of the air gaps.

According to a fourth embodiment, which may be based on the first, second or third embodiment, the throughput of the air gap formation process is increased by using the same CVD reactor for performing the heating step to decompose the disposable layer and for depositing the trench dielectric layer of a subsequent step. Preferably the heating is performed under an inert gas environment, like a nitrogen environment. Thus the usage of a stand-alone oven for the decomposing of the disposable layer can be omitted whereby decreasing the required amount of apparatus and increasing the throughput. In other words, only one CVD reactor is used for decomposing the sacrificial layer to form the air gap and for subsequently depositing a CVD trench level dielectric layer with a low k-value.

Alternatively to the photo resist used as disposable layer in the above embodiments any organic polymer with a low mass, i.e. low amu, that decomposes somewhere between 300 - 500°C, preferably between 350-450°C, may be chosen, as this layer will be decomposed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, several of these means can be embodied by one and the same item of hardware. The mere fact that certain measures are recited in mutually different dependent claims does not indicate that a combination of these measures cannot be used to advantage.

Furthermore, any reference signs in the claims shall not be construed as limiting the scope of the claims.

## Claims

1. A method for manufacturing a semiconductor device having damascene structures with air gaps (AG), comprising the steps of:
- providing a substantially planar layer having a first metal layer (M1),
- depositing a via level dielectric layer (VL),
- patterning said via level dielectric layer (VL),
- at least partly etching said via level dielectric layer (VL),
- depositing a disposable layer (PR) on said at least partly etched via level dielectric layer (VL),
- patterning said disposable layer (PR),
- depositing a second metal layer (M2),
- planarizing said second metal layer (M2),
- depositing a permeable dielectric layer (PDL) after planarizing said second metal layer (M2), and
- removing said disposable layer (PR) through said permeable dielectric layer (PDL) to form air gaps (AG).

2. Method according to claim 1, further comprising the steps of:
- depositing a barrier layer (BL) on said patterned disposable layer (PR), and
- depositing a seed layer (SL) on said barrier layer (BL).

3. Method according to claim 2, further comprising the step of:
- depositing a further barrier layer after the planarizing of said second metal layer (M2),

4. Method according to any of the previous claims, wherein said disposable layer (PR) is a photo resist layer or an organic polymer with a low mass.

5. Method according to claim 4, further comprising the step of:
- spinning said photo resist layer (PR) on said at least partly etched via level dielectric layer (VL).

6. Method according to any of the previous claims, wherein said patterning and etching of said via level dielectric layer (VL) is adapted to form additional via holes in said via level dielectric layer (VL) to provide metal dummy structures in the via level dielectric layer (VL) after said removing step.

7. Method according to any of the previous claims, wherein a single CVD reactor is used for performing the removing step by heating to decompose the disposable layer (PR) and for depositing a trench dielectric layer in a subsequent step.

8. Semiconductor device having damascene structures with air gaps, comprising:
- a substantially planar layer having a first metal layer (M1),
- a patterned and at least partly etched via level dielectric layer (VL) on said first metal layer (M1),
- a patterned disposable layer (PR) deposited on said at least partly etched via level dielectric layer (VL),
- a planarized second metal layer (M2),
- a permeable dielectric layer (PDL) deposited on said planarized second metal layer (M2), and
- at least one air gap (AG) formed by removing said disposable layer (PR) through said permeable dielectric layer (PDL).
